(19) Europäisches Patentamt

**European Patent Office**

**Office européen des brevets**

(11) Numéro de publication: **0 263 023 B1**

(12) **FASCICULE DE BREVET EUROPEEN**

(45) Date de publication de fascicule du brevet: **06.05.92** (51) Int. Cl.⁵: **H01H 13/70**, **H05K 7/02**

(21) Numéro de dépôt: **87402158.7**

(22) Date de dépôt: **28.09.87**

(54) **Commutateur électrique, notamment pour la commande d'équipements et accessoires automobiles.**

(30) Priorité: **02.10.86 FR 8613740**

(43) Date de publication de la demande:
**06.04.88 Bulletin 88/14**

(45) Mention de la délivrance du brevet:
**06.05.92 Bulletin 92/19**

(84) Etats contractants désignés:
**DE ES GB IT SE**

(56) Documents cités:
**CH-A- 472 170**
**DE-A- 2 717 372**
**DE-A- 3 135 139**
**DE-A- 3 441 337**

(73) Titulaire: **DAV, Société dite**
**Vétraz-Monthoux B.P. 85**
**F-74101 Annemasse Cédex(FR)**

(72) Inventeur: **Saulgeot, Jean-Michel**
**Le Faubourg**
**F-74380 Lucinges(FR)**
Inventeur: **Lepine, Gérard**
**7, rue des Alpes**
**F-74100 Ambilly(FR)**
Inventeur: **Caillon, Claude**
**200 route de la Combe**
**F-74160 Collonges Sous Salève(FR)**

(74) Mandataire: **Levy, David et al**
**c/o S.A. Fedit-Loriot 38, avenue Hoche**
**F-75008 Paris(FR)**

## Description

La présente invention concerne un commutateur électrique et, plus particulièrement, un commutateur formant un ensemble de commutation électrique, notamment pour la commande des équipements et accessoires à bord des automobiles.

On sait que des équipements et accessoires électriques de plus en plus nombreux sont montés à bord des automobiles et qu'un bon nombre d'entre eux, du fait de leur consommation de courant relativement élevée, nécessitent, pour leur commande, un ensemble comprenant un organe manuel de commutation pour courants faibles (par exemple un interrupteur), disposé à portée de l'utilisateur, et un circuit de puissance comportant des relais (électromagnétiques, statiques) ou des transistors de puissance.

De plus, le fonctionnement de certains de ces équipements et accessoires est maintenant géré par des circuits électroniques de gestion de commande. C'est ainsi qu'on peut prévoir, par exemple, une temporisation électronique, une commande par appui fugitif sur une touche de commutateur, une sélection de plusieurs fonctions, une commande progressive par impulsions, la détection et la prise en compte de divers paramètres, etc.

Des exemples d'application sont la commande automatique des lève-vitres ou la commande d'une lunette arrière chauffante avec temporisation.

Les ensembles de commande pour de tels appareils comprennent ainsi trois éléments : un organe manuel de commutation pour courants faibles ou commutateur proprement dit -une partie électronique de gestion de fonction-des organes de commutation en courants élevés ou circuit de puissance (relais) pour commander la charge.

Jusqu'à présent, les deux derniers éléments étaients logés chacun dans un boîtier (ou parfois dans un boîtier commun), ce ou ces boîtiers étant reliés par des faisceaux de câbles au commutateur manuel de commande et, éventuellement, entre eux par un autre faisceau de câbles et à la charge.

Cette configuration a pour effet d'introduire des connexions et un câblage de liaison, dit "connectique", important entre les éléments constituant l'ensemble des commutations, donc d'un coût relativement élevé par rapport aux organes eux-mêmes, notamment lorsqu'il s'agit de commandes unitaires et de fonctions simples.

Par ailleurs, le montage de cette "connectique" à bord de l'automobile prend un certain temps de main-d'oeuvre et l'existence de liaison avec "connectique" est un facteur de limitation du niveau de fiabilité.

On connaît par le document DE-A-2 717 372 un appareil de commande d'amplificateur qui comprend un boîtier, un panneau de commande comprenant des touches, des plaques-circuit superposées incorporées au boîtier et disposées globalement parallèlement au panneau de commande, ainsi que des organes de connexion, tels que des languettes, pour raccordement à l'appareil à commander. Ce document, n'a pas de rapport avec les équipements automobiles.

L'invention a pour but de remédier à ces inconvénients, grâce à une configuration nouvelle des divers éléments permettant de réaliser un ensemble de commutation compact.

L'invention a pour objet le commutateur défini dans la revendication 1 annexée.

Grâce à l'invention, on regroupe en un seul boîtier (celui du commutateur lui-même), les divers éléments d'un ensemble de commutation.

La disposition en deux étages des circuits de gestion et de puissance permet de conserver au boîtier du commutateur une surface projetée limitée, qui n'est pas supérieure à la surface projetée d'un commutateur classique sans fonction de gestion ni de puissance, ce qui permet donc l'interchangeabilité dans les emplacements normalement prévus pour encastrement sur une planche de bord ou analogue.

Par rapport à un commutateur classique, le commutateur suivant l'invention a un encombrement augmenté dans le sens de la profondeur, mais, dans la quasi-totalité des applications on n'est pas limité dans ce sens.

De préférence, les deux plaques-circuit sont solidarisées entre elles par des colonnettes métalliques jouant également le rôle de connexion électriques entre les circuits des deux plaques.

Suivant un mode de réalisation avantageux, la plaque-circuit supérieure porte, sur sa surface supérieure, des pistes conductrices constituant des contacts fixes qui coopèrent avec le ou les contacts mobiles portés par la ou les touches du commutateur, les composants électroniques du circuit de gestion étant montés sur la face opposée, c'est-à-dire la face inférieure, de cette même plaque-circuit.

L'invention sera mieux comprise à la lecture de la description détaillée qui va suivre et à l'examen des dessins annexés qui représentent, à titre d'exemples non limitatifs plusieurs modes de réalisation de l'invention.

La figure 1 est une vue en coupe d'un commutateur suivant l'invention pour une commande de lève-vitre d'automobile.

La figure 2 est une vue en coupe suivant la ligne II-II de la figure 1.

La figure 3 est une vue en élévation, avec certaines parties arrachées, d'un autre mode de réalisation d'un commutateur pour la commande temporisée d'une lunette chauffante.

La figure 4 est une vue en bout du même commutateur.

La figure 5 est une vue de dessus du même commutateur.

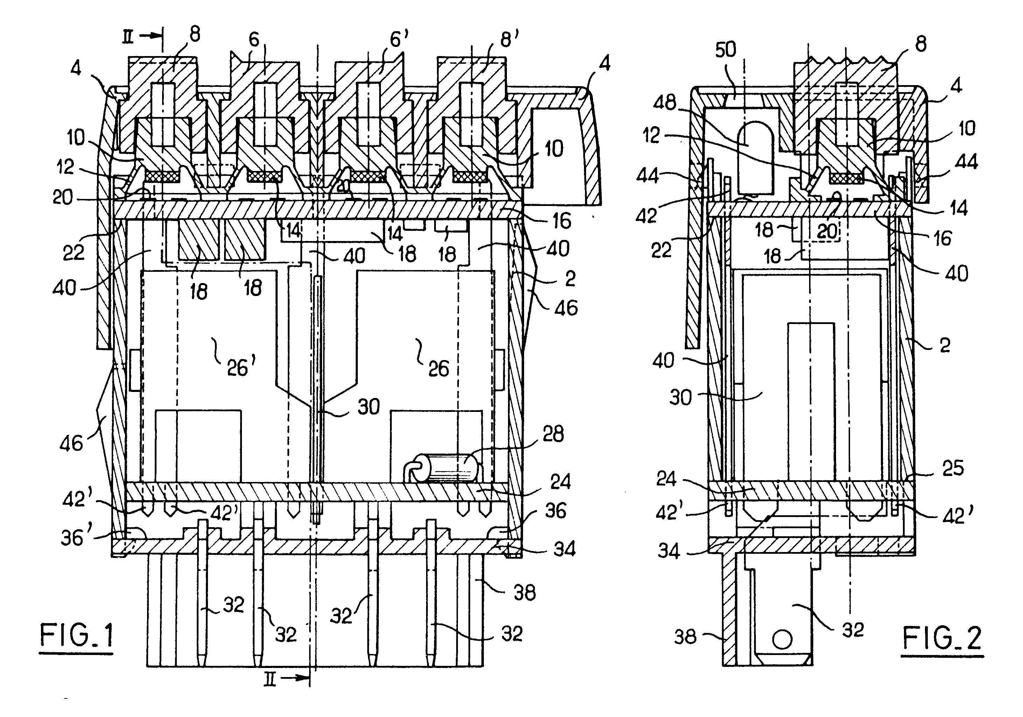

Le commutateur représenté sur les figures 1 et 2 comprend un boîtier 2 coiffé à la partie supérieure par un cache supérieur 4 percé d'ouvertures pour le passage et le guidage des touches de commande manuelle. Le boîtier 2 est une pièce moulée en forme de manchon tubulaire à section rectangulaire.

Dans le mode de réalisation représenté, le commutateur comprend quatre touches : deux touches centrales 6, 6' pour la montée et la descente directe de la vitre, deux touches latérales 8, 8' pour la montée et la descente dites automatiques, par impulsion sur l'une ou l'autre de ces touches.

Les touches sont creuses à leur partie inférieure et s'emmanchent dans les protubérances 10 d'une membrane cloquante 12, chaque protubérance 10 portant à sa partie inférieure, de façon classique, une pastille conductrice 14.

Le commutateur comporte, incorporé à son boîtier 2, un circuit électronique de gestion qui est porté par une carte-circuit supérieure 16. Dans l'exemple de réalisation représenté d'une commande pour lève-vitre, ce circuit électronique peut avoir pour fonctions l'arrêt automatique du moteur en fin de course, le maintien du signal résultant d'une impulsion sur une touche, la sélection prioritaire d'une commande par rapport à une autre, etc.

Ce circuit électronique de gestion comprend un certain nombre de composants 18 (condensateurs, transistors, amplificateurs opérationnels, etc.) qui sont montés sur la face inférieure de la plaque 16, par soudage à plat sur cette face.

La face supérieure de la plaque 16 supporte des pistes de contact 20 en regard avec les pastilles conductrices 14 de la membrane 12. La plaque 16 est constituée par un circuit imprimé double face possédant des traversées électriques entre faces (trous métallisés) et elle s'appuie sur des rebords supérieurs 22 du boîtier 2 avec lequel elle est solidaire.

Au boîtier du commutateur est également incorporé un deuxième étage, ou étage de puissance, qui est porté par une plaque-circuit inférieure 24. Cette plaque 24 est constituée par un circuit imprimé simple face dont l'épaisseur de cuivre est appropriée aux courants forts à véhiculer en sortie. La plaque 24 prend appui sur des décrochements 25 à la partie inférieure du boîtier 2.

L'étage de puissance peut comporter, dans le cas d'un lève-vitre, deux relais électromagnétiques (ou statiques) 26, 26', un pour la montée, un pour la descente, qui sont montés sur la face supérieure de la plaque 24 et dont les bobines (ou analogues) sont excitées par les signaux à courant faible générés par le circuit de gestion.

La face supérieure de la plaque 24 peut également supporter un ou plusieurs composants électroniques conventionnels 28 ainsi que des composants de puissance, tels qu'un shunt résistif 30 de détection du courant absorbé par l'appareil (tel qu'un moteur de lève-vitre) à commander. Dans l'exemple représenté sur les figures 1 et 2, ce shunt résistif 30 est une pièce plate en U, découpée à partir de métal résistif en bande, qui est intercalée entre les deux relais 26, 26'.

On obtient ainsi un très faible encombrement qui contribue à permettre l'intégration dans le boîtier du commutateur du circuit de gestion à courant faible et du circuit de puissance.

Sur la plaque inférieure 24 sont soudées des languettes enfichables de connexion 32, ou organes analogues de raccordement, qui émergent sur la face inférieure de la plaque 24, en vue de leur raccordement à un connecteur femelle correspondant.

Ces languettes 32 traversent le fond 34 du boîtier 2, ce fond étant une pièce moulée qui est maintenue par clipsage en 36, 36' sur la partie inférieure du boîtier. Le fond 34 est prolongé vers le bas par une partie 38 assurant le guidage et le détrompage du connecteur enfichable.

Les deux plaques-circuit superposées 16 et 24 sont réunies entre elles, mécaniquement et électriquement, par des colonnettes de liaison ou entretoises 40, par exemple trois colonnettes de chaque côté. Ces colonnettes sont plates, découpées à partir de métal en bande, et soudées sur chacun des deux circuits portés par les plaques 16 et 24. Les extrémités de chaque colonnette sont en forme de dents (simples ou doubles) 42, 42' qui traversent les plaques 16 et 24 pour assurer leur positionnement et qui sont soudées aux points appropriés des circuits imprimés.

Une fois assemblés avec le boîtier 2, les plaques 16, 24 et le fond 34 forment un ensemble compact qui peut être coiffé d'un cache supérieur 4, d'un type ou d'un autre, retenu sur le boîtier par clipsage au moyen de dents 44 faisant saillie à la partie supérieure du boîtier 2. Le boîtier 2 comporte encore, venues de moulage, des pattes latérales de clipsage 46 pour l'encastrement dans la planche de bord du commutateur.

Comme on le voit sur les figures 1 et 2, la disposition du circuit de gestion et du circuit de puissance sur deux plaques 16 et 24 superposées permet de donner à l'ensemble incorporé dans le boîtier 2 une surface transversale qui n'excède pas la surface frontale utile, portant les touches 6, 6', 8, 8', du commutateur, c'est-à-dire que le commutateur suivant l'invention peut se loger en remplacement d'un commutateur classique, seul l'encombrement en hauteur étant augmenté.

La plaque-circuit supérieure 16 peut également supporter une lampe ou diode électroluminescente 48 qui éclaire, directement ou par l'intermédiaire d'un conduit lumineux, des témoins de fonction 50 prévus sur le cache 4.

On a représenté sur les figures 1 et 2, comme organes de commutation de puissance des relais ou micro-relais électromagnétiques 26, 26', mais ces composants peuvent être remplacés par des semiconducteurs de puissance, supportés par la plaque 24 et munis d'une partie formant radiateur de dissipation thermique.

Bien entendu, certaines des touches 6, 6', 8, 8' à enfoncer peuvent être remplacées par une (ou des) touches basculantes d'un inverseur classique.

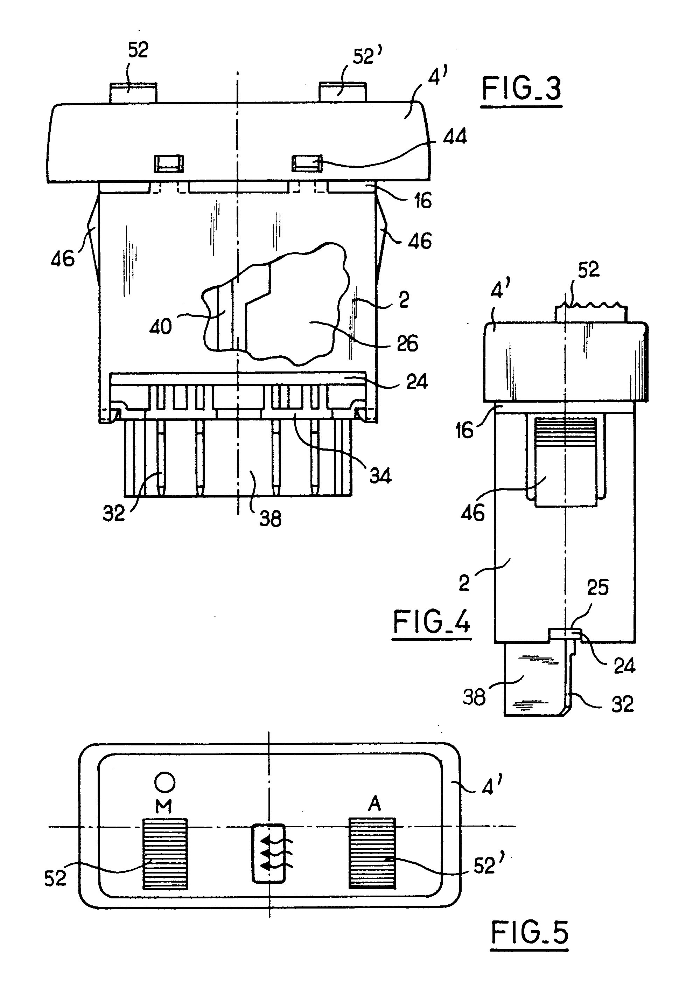

On a représenté sur les figures 3, 4 et 5 un autre mode de réalisation d'un commutateur suivant l'invention pour application à la commande, avec temporisation, d'une lunette arrière chauffante. Les mêmes éléments portent les mêmes chiffres de référence que sur les figures 1 et 2. Le boîtier 2 est identique à celui précédemment décrit et constitue une pièce standard pour les divers types de commutateurs.

Le cache supérieur 4' a une forme différente du cache 4 représenté sur les figures 1 et 2, mais il est enclipsé sur le boîtier 2 par les mêmes dents 44 faisant partie du boîtier.

Le cache supérieur 4' est prévu pour deux touches Marche-Arrêt 52, 52'. La mise en marche avec temporisation s'effectue par appui fugitif sur la touche 52. L'arrêt se produit soit à la fin de la temporisation, soit par appui fugitif sur la touche 52'.

Le circuit électronique de gestion porté par laplaque supérieure 16 assure donc les fonctions de maintien d'un ordre fugitif et de temporisation pendant la durée fixée. Le circuit de puissance comporte dans ce cas un seul micro-relais 26, porté par la plaque inférieure 24.

A titre d'exemple on peut indiquer que, dans le cas des figures 1, 2 comme dans le cas des figures 3 à 5, le boîtier 2 peut avoir, comme les plaques 16 et 24, une longueur L de 36 mm environ et une largeur l de 18 mm environ, ce qui permet l'encastrement d'un commutateur suivant l'invention en remplacement d'un commutateur classique.

Bien entendu, le commutateur peut être adapté à toute autre fonction de gestion et de commande que celles décrites dans ce qui précède. C'est ainsi que le commutateur peut être prévu pour assurer une commande progressive réalisée à partir de deux touches de commande " + " et "-", ou bien que plusieurs types de commandes peuvent être intégrés dans le commutateur, les touches de commande pouvant alors être regroupées en clavier.

**Revendications**

1. Commutateur pour la commande d'un appareil électrique, notamment pour la commande d'un équipement ou accessoire à bord d'une automobile, qui comprend un boîtier (2), un panneau de commande comprenant au moins un organe manuel de commande, tel qu'une touche (6, 6', 8, 8'), deux plaques-circuit superposées incorporées au boîtier et disposées globalement parallèlement audit panneau de commande, ainsi que des organes de connexion, tels que des languettes de connexion (32), pour raccordement à l'appareil à commander, ledit commutateur étant caractérisé en ce que la plaque supérieure (16) porte sur sa face supérieure des pistes conductrices (20) coopérant avec des contacts mobiles (14) actionnés par ledit organe de commande (6, 6', 8, 8') et sur sa face inférieure au moins des composants électroniques (18) constituant un circuit électronique de gestion de fonction à courant faible, et en ce que la plaque inférieure (24) supporte un circuit de puissance comportant au moins un organe de commutation à courant fort, notamment un relais (26, 26').

2. Commutateur suivant la revendication 1, caractérisé en ce que les deux plaques-circuit (16,24) sont reliées entre elles, mécaniquement et électriquement par des colonnettes de liaison (40).

3. Commutateur suivant la revendication 2, caractérisé en ce que les colonnettes de liaison (40) sont soudées aux deux plaques-circuit.

4. Commutateur suivant l'une des revendications 1 à 3, caractérisé en ce que le boîtier (2) est en forme de manchon tubulaire à section rectangulaire et en ce que les deux plaques-circuit (16,24) prennent appui sur des bords ou décrochements (22,25) supérieurs ou inférieurs du boîtier (2).

5. Commutateur suivant l'une des revendications 1 à 4, caractérisé en ce que les contacts mobiles sont constitués par des pastilles conductrices (14) portées par une membrane cloquante (12).

6. Commutateur suivant l'une des revendications précédentes, caractérisé en ce qu'il est destiné à la commande d'un lève-vitre d'automobile et en ce que le circuit de commutation de puissance comporte deux relais électromagnétiques ou statiques (26,26') portés par la plaque inférieure (24), ladite plaque portant également un shunt résistif plat (30) disposé entre les deux relais.

7. Commutateur suivant l'une des revendications 1 à 5, caractérisé en ce qu'il est destiné à la commande avec temporisation d'une lunette chauffante, et en ce que la fonction de temporisation est assurée par le circuit électronique porté par la plaque supérieure (16) et en ce que la plaque inférieure (24) porte un relais unique (26) commandant l'alimentation de la lunette chauffante.

**Claims**

1. A switch for the control of an electrical device, especially for the control of an outfit or fitting on a car, which comprises a casing (2) and a control board comprising at least one control manual device, such as a key (6, 6', 8, 8'), two superposed circuit-boards incorporated in the casing and arranged generally in parallel with said control board, as well as connecting devices, such as connecting plugs (32) for junction to the apparatus to be controlled, said switch being characterized in that the upper board (16) carries on its upper face conductive tracks (20) cooperating with mobile contacts (14) operated said control device (6,6', 8, 8') and on its lower face at least electronic components (18) making up a function control electronic circuit for weak current, and in that the lower board (24) carries a power circuit comprising at least one high intensity switching device, especially a relay (26, 26').

2. A switch according to claim 1, in which the two circuit boards (16, 24) are connected together, mechanically and electrically, by means of linking pillars (40).

3. A switch according to claim 2, characterized in that the linking pillars (40) are welded to the two circuit-boards.

4. A switch according to one of claims 1 to 3, characterized in that the casing(2) is tubular sleeve-shaped with a rectangular section and the two circuit boards (16, 24) rest on the upper or lower edges or recesses (22, 25) of casing (2).

5. A switch according to one of claims 1 to 4, characterized in that the mobile contacts are made up of conductive chips (14) carried by a snap diaphragm (12).

6. A switch according to one of the previous claims device, characterized in that it is intended for the control of a car window lifting and in that the power switching circuit comprises two electromagnetic or static relays (26, 26') carried by the lower board (24), said board also carrying a flat resistive shunt (30) arranged between both relays.

7. A switch according to one of claims 1 to 5, characterized in that it is intended for the delay control of a window heating device, and in that the delay function is insured by the electronic circuit carried by upper wafer (16) and wherein lower board (24) carries a single relay (26) which monitors the feed power supply of the window heating device.

**Patentansprüche**

1. Schalter für die Steuerung eines elektrischen Geräts, insbesondere für die Steuerung einer Anlage oder Ausrüstung an Bord eines Fahrzeugs, der ein Gehäuse (2), eine Steuertafel mit wenigstens einem Handbetätigungsorgan wie einer Taste (6, 6', 8, 8'), zwei übereinanderliegende Schaltungsplatten, die in das Gehäuse eingegliedert sind und im wesentlichen parallel zur Steuertafel angeordnet sind, sowie Anschlußorgane wie Anschlußzungen (32) zur Verbindung mit dem zu steuernden Gerät besitzt, dadurch gekennzeichnet, daß die obere Platte (16) auf ihrer Oberseite leitende Bahnen (20), die mit beweglichen, durch das Betätigungsorgan (6, 6', 8, 8') betätigten Kontakten (14) zusammenwirken, und auf ihrer Unterseite wenigstens elektronische Bauelemente (18) trägt, die eine elektronische Schaltung zur Funktionssteuerung mit schwachem Strom bilden, und daß die untere Platte (24) eine Leistungsschaltung trägt, die wenigstens ein Schaltorgan mit starkem Strom, insbesondere ein Relais (26, 26'), aufweist.

2. Schalter nach Anspruch 1, dadurch gekennzeichnet, daß die beiden Schaltungsplatten (16, 24) miteinander mechanisch und elektrisch durch Verbindungssäulen (40) verbunden sind.

3. Schalter nach Anspruch 2, dadurch gekennzeichnet, daß die Verbindungssäulen (40) an die beiden Schaltungsplatten angelötet sind.

4. Schalter nach einem der Ansprüche 1 bis 3, dadurch gekennzeichnet, daß das Gehäuse (2) die Form einer rohrförmigen Buchse mit rechteckigem Querschnitt besitzt und daß die beiden Schaltungsplatten (16, 24) auf oberen oder unteren Rändern oder Absätzen (22, 25) des Gehäuses (2) aufliegen.

5. Schalter nach einem der Ansprüche 1 bis 4, dadurch gekennzeichnet, daß die beweglichen Kontakte aus leitenden Plättchen (14) bestehen, die von einer Blasen aufweisenden Membran (12) getragen sind.

6. Schalter nach einem der vorhergehenden Ansprüche, dadurch gekennzeichnet, daß er zur Steuerung eines Fahrzeug-Fensterhebers bestimmt ist und daß die Leistungsschaltung zwei elektromagnetische oder statische Relais (26, 26') aufweist, die von der unteren Platte (24) getragen sind, wobei diese Platte außerdem einen flachen resistiven Shunt (30) trägt, der zwischen den beiden Relais angeordnet ist.

7. Schalter nach einem der Ansprüche 1 bis 5, dadurch gekennzeichnet, daß er zur Steuerung einer heizbaren Heckscheibe mit Verzögerung bestimmt ist, daß die Verzögerungsfunktion durch die von der oberen Platte (16) getragene elektronische Schaltung gewährleistet ist und daß die untere Platte (24) ein einziges Relais (26) trägt, das die Speisung der heizbaren Heckscheibe steuert.

FIG.1

FIG.2

FIG.3

FIG.4

FIG.5